## Europäisches Patentamt
## European Patent Office
## Office européen des brevets

(19)

(11) Numéro de publication: **0 002 996**
**B1**

(12) **FASCICULE DE BREVET EUROPEEN**

(45) Date de publication du fascicule du brevet: **29.09.82**

(21) Numéro de dépôt: **78430019.6**

(22) Date de dépôt: **17.11.78**

(51) Int. Cl.³: **H 01 L 23/34,**
**C 23 C 13/00, C 23 C 15/00**

(54) **Support de dispositifs actifs à l'état solide, son procédé de fabrication et son utilisation dans un dispositif de refroidissement par fluide de tels dispositifs.**

(30) Priorité: **19.12.77 US 861931**

(43) Date de publication de la demande:
**11.07.79 Bulletin 79/14**

(45) Mention de la délivrance du brevet:
**29.09.82 Bulletin 82/39**

(84) Etats contractants désignés:
**DE FR GB**

(56) Documents cités:
CH - A - 207 351
DE - A - 2 227 747
DE - A - 2 441 613
DE - A - 2 546 444
US - A - 4 047 198

IEM TECHNICAL DISCLOSURE BULLETIN, vol. 19, (février 1977), no. 9, page 3622. V. J. SILVESTRI "Forming Porous Aluminium". JOURNAL OF APPLIED PHYSICS, vol. 41, (février 1970), no. 2, pages 742—748. A. J. STIRLING et al., Investigation of the sputtering of aluminium using atomic-absorption spectroscopy".

(73) Titulaire: **International Business Machines Corporation**
**Armonk, N.Y. 10504 (US)**

(72) Inventeur: **Sachar, Kenneth Selig**
**499 North Broadway**
**White Plains New York 10603 (US)**
Inventeur: **Silvestri, Victor Joseph**
**69 Byram Lake Road**
**Mount Kisco New York 10549 (US)**

(74) Mandataire: **Gallois, Gérard**
**COMPAGNIE IBM FRANCE Département de Propriété Industrielle**
**F-06610 - La Gaude (FR)**

(56) Documents cités:
RCA REVIEW, vol. 31 (juin 1970), no. 2, pages 276—292. J. L. VOSSEN et al., "Evaporation of aluminium with rf-induced substrate bias".
IBM TECHNICAL DISCLOSURE BULLETIN, vol. 19, (juillet 1976), no. 2, pages 460—461. J. B. PEARSON: "Integrated circuit chip cooling".

Courier Press, Leamington Spa, England.

**0 002 996**

Support de dispositifs actifs à l'état solide, son procédé de fabrication et son utilisation dans un dispositif de reproidissement par fluide de tels dispositifs

Domaine technique

La présente invention concerne les dispositifs actifs à l'état solide et, plus particulièrement, le refroidissement par fluide de tels dispositifs.

Etat de la technique antérieure

L'ébullition est l'un des procédés employés pour transférer la chaleur qui fait appel à l'emploi de liquides et qui nécessite le moins d'équipement et de frais. Lors d'une opération d'ébullition, des poches de vapeur au niveau d'une surface chaude que l'on désire refroidir engendrent de façon répétée des bulles qui, lorsqu'elles s'échappent, provoquent une agitation du fluide à proximité immédiate de cette surface chaude. Dans la plupart des procédés de convection de liquide forcée, il est difficile de contraindre lës liquides chaude et relativement froids à se combiner de façon intime à proximaté de la surface chaude. Le liquide froid est mis en contact avec la surface chaude et, lorsqu'il est chauffé, est contraint à se déplacer vers le haut. Lorsqu'elles montent, les bulles se dilatent cependant que le fluide qui se trouve sur la surface chaude s'évapore. Ce processus se produit initialement au niveau de la surface chaude avec l'évaporation d'un mince film de fluide au-dessous d'une bulle, ce film étant appelé microcouche. Une partie seulement de la chaleur transférée depuis la surface se présente sous la forme d'une chaleur latente à l'intérieur des bulles, la plus grande partie de la chaleur étant transféré par des courants de convection du liquide. A cet égard, on se reportera à l'article de G. Leppert intitulé "Boiling", paru dans "Advances in Heat Transfer", Vol. 1, page 185 (1964).

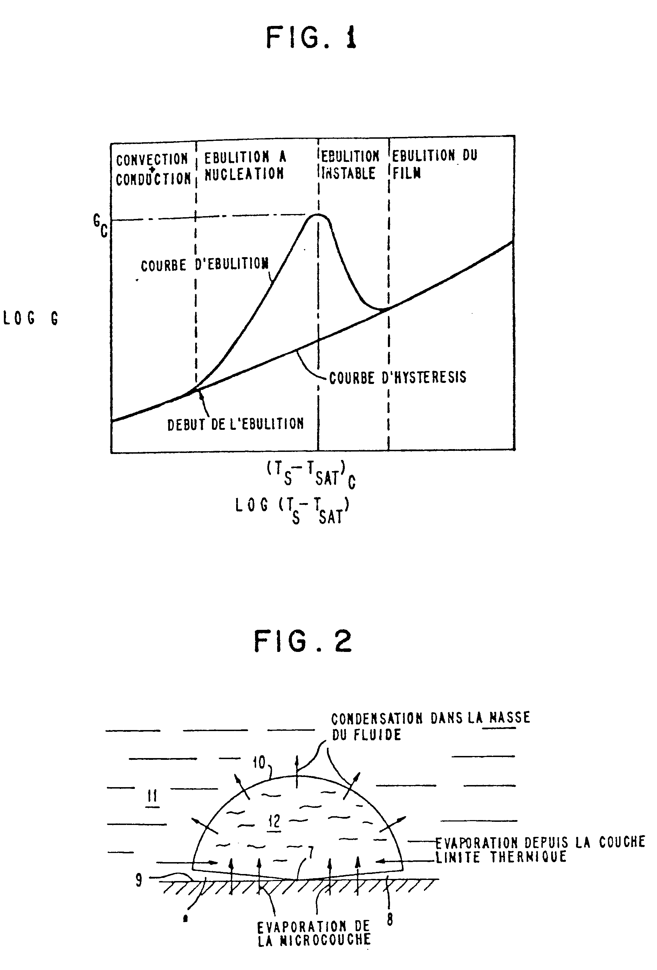

Les résultats obtenus prennent généralement la forme d'une courbe d'ébullition telle que celle de la figure I qui représente le flux d'énergie G (watts/m$^2$) en fonction de la différence de température $T_s$—$T_{sat}$, celle-ci étant désignée ci-après "superchaleur". $T_s$ est la température de la surface et $T_{sat}$ la température de saturation du fluide à la pression de fonctionnement (soit approximativement la température de l'ensemble du fluide). L'amélioration qui se produit dès le début de l'ébullition est évidente. Il est important de noter que le système présente une instabilité inhérente, comme le montre le fait qu'un flux de chaleur légèrement supérieur au flux critique $G_c$ provoque une brusque augmentation de la température de la surface. Etant donné qu'une nouvelle température de fonctionnement pour un G supérieur à $G_c$ présente souvent une valeur excessive (au-delà de la courbe de la figure 1), le point $G_c$ est parfois appelé point de "brûlure". Un tel comportement permet de distinguer les systèmes liquides de ceux qui font appel à une conduction ou à une convection gazeuse (naturelle ou forcée). Dans le cas de conducteurs solides ou de gaz, un meilleur rendement est obtenu lorsque la différence de température entre celle de la surface chaude et celle du milieu ambiant augmente. Les systèmes sont toujours stables. Le problème qui se pose à l'intérieur des liquides concerne la formation des bulles. Lorsque la chaleur engendrée à la surface augmente, les bulles sont engendrées plus rapidement et en des points plus rapprochés les une des autres. Les suites de bulles qui s'échappent interfèrent les unes avec les autres. On atteint finalement un point où les différentes suites de bulles se combinent et forment un film de vapeur qui maintient le liquide en suspension au-dessus de la surface que l'on désire refroidir.

La fiabilité constitus une autre limitation des techniques basées sur l'ébullition. En effet, pour être efficace, il est indispensable que l'ébullition se produise de façon reproductible lorsque le flux de chaleur ou la température atteint un certain niveau. Or, il n'est pas rare que cette condition ne soit pas satisfaite, par suite d'un nombre insuffisant de points de nucléation stables (points où on les bulles tendent à se former) sur la surface. Etant donné que le transfert de chaleur s'effectue d'une façon beaucoup plus efficace dans le cas d'une ébullition que dans le cas d'une convection naturelle, la température diminue de façon saisissante dès le début de l'ébullition. Cette hystérésis est particulièrement indésirable dans le cas des systèmes dans lesquels le niveau de puissance varie. Le système peut fonctionner à des températures nettement plus élevées à des niveaux de puissance faibles qu'à des niveaux de puissance élevés. Les effets des problèmes ci-dessus peuvent être considérablement atténués grâce à l'emploi des surfaces de nucléation artificielles décrites plus loin.

Etant donné que l'efficacité de l'ébullition est liée de façon intime à la génération des bulles, de nombreux travaux ont été effectués pour comprendre le processus en présence duquel on se trouve. Pendant qu'une bulle 10 représentée sur la figure 2 adhère à une surface que l'on désire refroidir, une certaine évaporation se produit au travers d'un mince film annulaire 8 de fluide situé au-dessous de la bulle, ce film étant appelé microcouche. A cet égard, on pourra consulter les articles de H. H. Jawurek intitulé "Simultaneous Determination of Microlayer Geometry and Bubble Growth in Nucleate Boiling" et de Cooper et al intitulé "The Microlayer in Nucleate Pool Boiling" respectivement parus dans la publication intitulée "Int. J. Heat Mass Trans.", *12*, 843 (1969) et *12*, 895 (1969); ceux de R. Mesler intitulé "A mechanism Supported by Extensive Experimental Evidence to Explain High Heat Fluxes Observed During Nucleate Boiling", et celui de Foltz et al intitulé "The Measurement of Surface Temperatures with Platinum Films During Nucleate Boiling of Water", respectivement parus dans la publication intitulée "AICHE J.", *12* 246 (1976) et *16*, 44 (1970); et celui de Voutsinos et al intitulé "Laser Interferometric Investigation of the Micro-Layer Evaporation Phenomenon", paru dans la publication "J.

Heat Trans.", *97*, 88 (1975). Lorsque l'évaporation se produit, il se forme une zone sèche 7 de la surface 9 au centre de la bulle 10. Le coefficient de transfert de chaleur de la couche 8 est extrêmement élevé. Un meilleur rendement peut être obtenu en faisant en sorte que l'évaporation de la microcouche ait lieu sur une zone plus importante ou pendant un intervalle de temps plus long.

Il est plus intéressant d'étudier la façon dont les bulles peuvent être engendrées de façon fiable avec une faible "superchaleur" ($T_s$—$t_{sat}$). Si une bulle est en suspension dans un liquide il existe une différence de pression entre le gas et le liquide.

La pression en excédent est absorbée par la tension superficielle de l'interface. Si S représente cette tension et si r est le rayon de la bulle, la différence entre la pression de la vapeur contenue dans la bulle, $p_v$, et la pression du liquide (immédiatement à l'extérieur de la bulle), $p_l$, est:

$$p_v\text{—}p_l = 2S/r \qquad (1)$$

Si la bulle se trouve dans un état d'équilibre, la poche de vapeur ne fait l'objet d'aucune dilatation ou d'aucune contraction. En pareil cas, la relation qui existe entre les pressions afférentes aux phases vapeur et liquide est définie par l'équation de Clapeyron (cf. l'article de Cole intitulé "Boiling Nucleation" paru dans "Advances in Heat Transfer", *10*, 84, 95 (1974)):

$$p_v\text{—}p_l \simeq p_v L(T_{be}\text{—}T_{sat})/T_{sat} \qquad (2)$$

$T_{sat}$ est la température associée à un bain de liquide de dimensions infinies qui est en équilibre avec sa vapeur et qui est exposé à une pression de liquide $p_l$. $T_{be}$ est la température moyenne d'équilibre de la vapeur contenue dans la bulle et du liquide, cette température étant compatible avec la différence de pression (c'est-à-dire qu'il ne se produit aucune dilatation ou aucune contraction). L est la chaleur latente du liquide, et $\rho_v$ est la densité de la vapeur. En combinant les deux équations ci-dessus, on obtient la variation de la température d'équilibre de la bulle en fonction de son rayon:

$$T_{be} = T_{sat}(1 + 2S/\rho_v Lr) \qquad (3)$$

Si la température effective de la bulle est supérieure à $T_{be}$, une bulle de rayon r se dilate. Si la température est plus basse, la bulle se contracte. L'équation (3) définit la température minimum qui est nécessaire pour provoquer une ébullition active à partir d'une bulle de rayon r. Il est évident que plus les dimensions initiales de la bulle sont importantes, plus le température requise pour provoquer une dilatation de cette bulle et une ébullition sera faible.

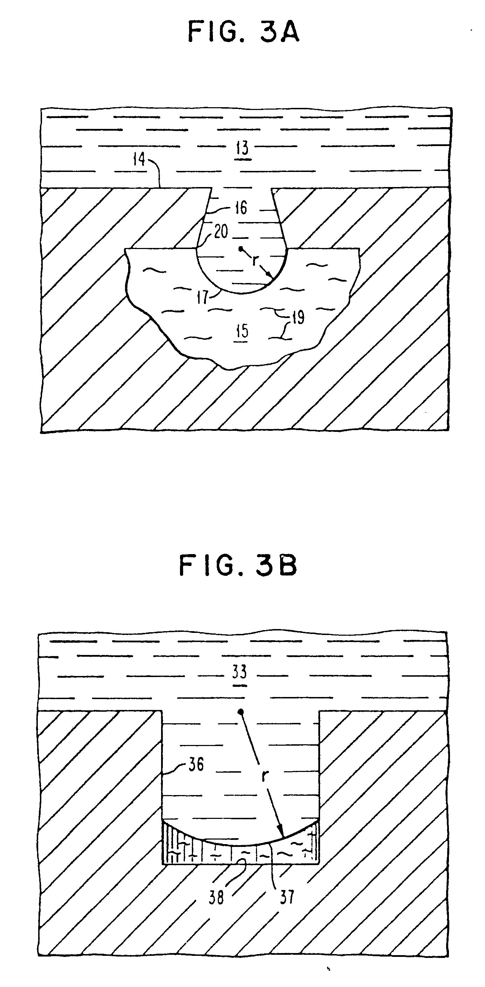

Si la surface chauffée est parfaitement lisse, comme le montre la figure 2, la génération d'une bulle 10 exige une "superchaleur" excessivement importante et peut aussi bien se produire dans la masse du fluide 11 que sur cette surface. Cela reflète la pression de vapeur importante d'un gaz 12 contenu dans un aussi faible volume. Dans le cas d'une surface 14 qui n'est pas lisse (voir figure 3A), la situation est complètement différente. Si des poches ou des cavités de vapeur stables 15 existent dans la surface ou sur celle-ci, des points de formation de bulles sont toujours disponibles. Plus la poche ou la cavité 15 est importante, plus faible sera la "superchaleur" nécessaire pour provoquer la dilatation des bulles. La fiabilité impose une limite en ce qui concerne leurs dimensions. Si les emplacements ont des dimensions trop importantes, ils deviennent inutilisables une fois remplis de liquide. Plusieurs chercheurs ont conclu qu'il existe une géométrie idéale pour un point de nucléation active—une cavité formant réservoir (cf. l'article de Hsu intitulé "On the Size Range of Active Nucleation Cavities on a Heating Surface", paru dans la publication "J. Heat Trans., *84*, 207 (1962); et Cole, op. cit.). Le fluide qui se trouve en contact avec la paroi du pore repousse l'interface liquide-vapeur vers le haut avec une force qui est inversement proportionnelle au rayon de courbure de l'interface, comme le montre la figure 3A. Si le pore est simplement une cavité cylindrique 36 (voir figure 3B), une fois que l'interface gaz-fluide 37 pénètre, le rayon de coubure r est fixe. Si la pression appliquée par le liquide 33 situé au-dessus est trop importante, l'interface 37 descend jusqu'au fond de la paroi 38 et la cavité 36 est remplie de liquide. Dans le cas d'une cavité 15 formant réservoir comme sur la figure 3A, lorsque l'interface 17 atteint le bord inférieur du pore 16, cette interface peut pivoter autour d'un coin 20. Ce faisant, la valeur du rayon de courbure r diminue avant d'augmenter de nouveau. Dans cette région, l'interface 17 est stable puisque, lorsque le liquide 13 cherche à pénétrer plus profondément dans la cavité 15, la tension de surface produit une force de plus en plus importante qui retarde le flux. En fonctionnement normal, la cavité 15 (voir figure 3A) que comporte la surface 14 d'un corps que l'on désire refroidir est initialement remplie d'une vapeur 19. Lorsque le liquide 13 forme une plus grande quantité de cette vapeur 19, le liquide 13 est chassé vers le haut au travers du pore 16 et une bulle (non représentée) s'échappe, ce qui se traduit par une diminution de la pression à l'intérieur de la cavité 15, si bien que l'interface 17 peut de nouveau avancer à l'intérieur du pore 16 et mettre le liquide 13 en contact avec les parois de ce dernier pour produire davantage de vapeur 19. Ce processus est beaucoup plus efficace que celui de la figure 2 parce que la formation de la vapeur 19 est facilitée par la présence d'une interface liquidevapeur 17 importante.

Tant que le ménisque (interface 17) peut soutenir le liquide 13 qui se trouve au-dessus de lui, la cavité 15 reste sèche. Le site reste actif parce qu'une interface liquide-vapeur macroscopique 17 est toujours disponible et que l'évaporation peut s'y produire. Il est permis d'avancer ici, à titre de grossière approximation, suffisante, que l'ébullition se produit lorsque le rayon de la bulle défini par l'équation (3) est égal au rayon de la cavité. Partant de cette hypothèse, si le liquide 13 est du fluorocarbone tel que le "Fréon 113", une "superchaleur" de 30°C exige une cavité de 0,4 micron, une "superchaleur" de 10°C exige une cavité de 1 micron, et une "superchaleur" de 1°C exige une cavité de 11 microns.

Plusieurs techniques peuvent être employées pour obtenir une surface continuellement active. La première consiste à définir une cavité dont la forme est susceptible d'être réalisée dans une surface et qui convient au type particulier de liquide de refroidissement et de matériau constituant la surface 14 du corps à recouvrir, puis à utiliser de telles cavités dans la surface 14 comme points de nucléation représentés sur la figure 3A. Pour que cette technique soit efficace, il faut en partie que les cavités 15 occupent des positions correctes. Si toutes ces conditions sont remplies, le transfert de chaleur peut présenter une amélioration considérable (voir l'article de Heled et al intitulé "Pool Boiling from Large Arrays of Artificial Nucleation Sites" paru dans la publication "Int. J. Heat Mass Trans.", 8, 1261 (1965)).

Une autre technique analogue consists à recouvrir une surface d'un ensemble de points, puis à utiliser un fluide de refroidissement pour mouiller la surface, mais non ces points. Il ne s'agit pas en l'occurrence de capter la vapeur, mais d'obtenir des emplacements où la vapeur pourra se développer plus facilement, Comme précédemment, l'espacement et les dimensions constituent des paramètres critiques. Par ailleurs, les propriétés de la surface telles que l'angle de contact diovent rester invariables.

Une autre technique tire parti du fait qu'une surface que l'on a rendue rugueuse présente de meilleures caractéristiques en ce qui concerne l'ébullition que lorsqu'elle était lisse (cf. l'article de Bergles intitulé "Recent Developments in Convective Heat Transfer Augmentation", paru dans la publication "App. Mech. Rev.", 26, 675 (1973)). Le fait de rendre la surface rugueuse crée apparemment un spectre d'emplacements de dimensions et d'activités variables. A de faibles flux de chaleur, seuls les emplacements les plus actifs agissent. A des flux plus élevés, d'autres emplacements deviennent agissants. Un procédé est nécessaire pour créer des emplacements actifs de façon selective. Une abrasion de surface effectuée au moyen de divers types de papier de verre a donné de bons résultats et permis de faire passer la courbe d'ébullition à des niveaux de "superchaleur" inférieurs. (Voir l'article de Corty et al intitulé "Surface Variables in Nucleate Boiling", paru dans la publication "Chem. Eng. Prog. Sym.", séries 51, 1 (1955)). L'emploi d'un revêtement constitué par une couche mince présentant une faible conductivité thermique et une faible capacité thermique, ou d'une couche de particules grossières, ou d'une couche d'un matériau poreux, permet d'augmenter le flux de chaleur critique $G_c$. (Voir l'article de Butler et al intitulé "Improved Pool Boiling Heat Transfer to Helium from Treated Surfaces and its Application to Super-conducting Magnets'''', paru dans la publication "Int. J. Heat Mass Trans.", 13, 105 (1970)). Tout ce qui a pour effet de détruire l'uniformité de la surface augmente la capacité qu'offre celle-ci de transférer la chaleur. En l'occurrence, l'objectif est de créer un nombre plus que suffisant d'emplacements actifs pour répondre aux besoins de n'importe quelle situation. Le système choisit le nombre approprié d'emplacements pour permettre un fonctionnement correct.

Les techniques mentionnées jusqu'ici sont passives. On sait qu'il existe des techniques actives permettant d'augmenter le transfert de chaleur. L'une de ces dernières fait appel à l'évaporation d'un film. Malheureusement, la plupart de ces procédés sont incompatibles avec les circuits intégrés. On a souvent proposé l'application de champs électriques permettant de chasser les bulles électriquement de la surface et de retarder le début de l'ébullition du film. Toutefois, ces résultats ne sont obtenus de façon notable que lorsqu'on utilise des champs électriques extrèmement importants rendant probable le claquage électrique du fluide.

Etant donné que la présente invention concerne en particulier le refroidissement de dispositifs actifs à l'état solide, il est nécessaire que les solutions proposées soient compatibles avec le traitement des dispositifs en silicium. Compte tenu des améliorations citées dans l'art antérieur, c'est surtout aux surfaces poreuses que l'on s'intéresse aux fins de la nucléation de liquides de refroidissement. Une comparaison est établie entre les résultats obtenus au moyen d'une technique donnée, dans le cas d'une surface an silicium décapée et dans celui d'une surface décapée et polie. Le premier cas correspond à la face arrière d'un bloc de circuits intégrés, et le dernier à la face avant sur laquelle le traitement est effectué. Les techniques employées sont les suivantes:

Sablage:

Un abrasif constitué par une poudre de particules d'oxyde d'aluminium d'un diamètre de 27 microns est entraîné au moyen d'un jet de gaz dans une unité d'abrasion. Quelques secondes suffisent pour rendre la surface rugueuse. Cette technique favorise le refroisissement.

Revêtements dendritiques:

On peut faire croître une couche de tungstène dendritique par dépôt en phase vapeur (cf. J. J. Cuomo, "Low to High-Temperature Capillary" dans la publication "IBM Technical Disclosure Bulletin", 18, 1239, septembre 1975, et Cuomo et al, "A New Concept for Solar Energy Thermal Conversion", dans la publication "Appl. Phys. Lett.", *26*, 557 (1975)). La surface est recouverte d'un ensemble de lames d'une hauteur d'environ 10 microns. Le dépôt en phase chimique exige l'emploi de températures élevées, ce qui rend cette technique inutilisable aux fins du traitement de substrate qui pourraient être endommagés par de telles températures. La structure obtenue présente une faible porosité et est ouverte, ce qui est exclut presque complétement le plégeage du gaz. Etant donné que le gas peut s'échapper, on ne peut obtenir une ébullition efficace. L'article de Bakelaar intitulé "Substrate. Mounted Heat Pipe for Chip Cooling", paru dans "IBM Technical Disclosure Bulletin", *14*, 2690 (février 1972) décrit un procédé dont l'objet est de permettre de recouvrir les surfaces d'un bloc de circuits intégrés liés par une soudure à un support, au moyen d'un type dendritique de matériau servant de mèche refroidi par un fluide diélectrique.

Silicium poreux pour refroissement:

Une pastille en silicium destinée à un dispositif semi-conducteur est décapée électrolytiquement lorsqu'elle est utilisée comme électrode dans une cellule électrolytique par anodisation en HF (cf. Gregor et al, "Porous Silicon Interface to Enhance Heat Transfer from Silicon Substrate to Liquid" dans la publication "IBM Technical Disclosure Bulletin", *19*, No. 3, 1120 (août 1976)). Les variations de la densité du courant et de la durée de l'application modifient l'épaisseur de la couche. Les dimensions et l'espacement des pores sont fonction du type de dopage (p ou n) du silicium et de la conductivité électrique. Dans le cas d'un dopage de type n, on constate la présence d'ouvertures côniques dirigées vers l'intérieur dont le plus grand diamètre est de quelques microns et de canaux latéraux qui relient ces ouvertures. Cela nécessite toutefois l'emploi d'un procédé chimique en phase humide qui présente l'inconvénient, lors de la fabrication de dispositifs à l'état solide, d'exposer leurs surfaces à des produits chimiques humides alors qu'elles devraient être protégées contre ces derniers.

Films poreux en général:

Une structure poreuse qui n'est pas destinée à être refroidie et qui se compose de cuivre est obtenue par pulvérisation réactive dans une atmosphère d'argon maintenue à une pression de 240 microns de Mercure (32 Pa) et à de faibles températures du substrat (cf. Thornton et al, "Tubular Hollow Cathode Sputtering onto Substrates of Complex Shape", dans "J. Vac. Sci. Technol.", *12*, No. 1, 93 (1975)). De l'aluminium poreux a été réalisé au moyen de techniques d'évaporation dans une atmosphère d'argon et l'on a montré que la pression de ce dernier pourrait être utilisée pour modifier la porosité (cf. Silvestri, "Forming Porous Aluminium" dans "IBM Technical Disclosure Bulletin", Vol. 19, No. 9, page 3622, février 1977). Par ailleurs, l'article de Miersch et Sachar intitulé "Enhancement of Boiling Heat Transfer by a Submerged Capillary Structure", paru dans "IBM Technical Disclosure Bulletin", Vol. 18, page 3843, avril 1976, décrit la formation d'une surface composée d'un matériau poreux présentant plusieurs couches, dont la couche supérieure comporte des jets régulièrement espacés. Les dimensions et l'espacement des pores sont des facteurs importants. La formation de cavités dans une surface adaptée aux fins d'un transfert de chaleur est obtenue grâce au procédé décrit dans le brevet des E.U.A. No. 4 050 507, qui consiste notamment à percer des trous dans la partie arrière d'une pastille au moyen d'un faisceau présentant une énergie élevée, telle qu'un laser, de manière à obtenir une ébullition avec nucléation. Toutefois, le dispositif est dans pareil cas exposé à une grande quantité de chaleur, ce qui aurait pour effet de détruire un grand nombre de dispositifs à films minces.

Canaux ou îlots:

L'article de Pearson intitulé "Integrated Circuit Chip Cooling" dans "IBM Technical Disclosure Bulletin", *19*, 460—1, juillet 1976, décrit l'emploi d'un film de silicium que l'on rend poreux de manière à retirer certaines régions où l'on désire former des canaux ou des évidements autour d'îlots. Tout le matériau poreux est retiré.

Structure poreuse macroscopique:

Le brevet des E.U.A. No. 3 739 235 décrit un procédé permettant de recouvrir un bloc au moyen de couches métalliques comportant un grand nombre de particules de cuivre recouvertes de soudure qui sont liées les unes aux autres pour former une structure capillaire poreuse extrêmement rugueuse. Cette structure est saturée par un fluide tel que de l'eau.

En général, l'art antérieur montre qu'il est souhaitable d'obtenir des structure poreuses comportant des cavités partiellement fermées. Toutefois, les techniques empoyées sont insatisfaisantes car elles n'offrent pas une capacité de refroidissement par unités de temps suffisante et/ou exigent des températures de fabrication si élevées qu'elles risques d'endommager les structures. Le fait de frotter un substrat avec du papier de verre ou de l'exposer à un sablage est insatisfaisant car (1) de la saleté et de la poussière risquent de demeurer sur le côté opposé du bloc et (2) l'efficacité d'un tel traitement, en ce qui concerne le refroidissement, est relativement médiocre, principalement parce que, superficiel, il ne permet d'obtenir aucune porosité. Par ailleurs, des trous réalisés par décapage par ions réactifs ou au moyen d'un laser ne permettent pas d'obtenir les pores communiquant entre cavités adjacentes

# 0 002 996

dont la présence semble être, selon la présente invention, indispensable pour obtenir une imprégnation adéquate du film de refroidissement.

Les revêments en tungstène dentritique peuvent permettre d'obtenir une imprégnation, mais non des cavités susceptibles de piéger le gaz, et exigent un dépôt chimique en phase vapeur à des températures trop élevées pour un grand nombre de dispositifs. Des techniques de décapage chimique en phase humide qui servent notamment à la formation de rainures risquent d'endommager le bloc et posant des problèmes de sécurité de l'opérateur et d'élimination des produits chimiques employés.

En résumé, l'utilisation de l'ébullition pour transférer de la chaleur en particulier pour le refroidissement des dispositifs actifs à l'état solide apparaît intéressante. Cependant, l'efficacité de l'ébullition est liée à la génération des bulles et par suite à la constitution de la surface où elles prennent naissance. D'où la nécessité de points de nucléation corrects. L'état de la technique concernant la fabrication et la structure des surfaces montre qu'il n'existe jusqu'ici aucune surface poreuse pleinement satisfaisante.

Exposé de l'invention

Selon la présente invention, un dispositif à l'état solide à film mince est formé sur un substrat. Le côté opposé du substrat est recouvert d'un film mince fortement poreux qui est déposé dans une chambre sous vide en présence d'une atmosphère gazeuse. Le film mince comprend des structures et des cavités capillaires microscopiques, ces cavités étant reliées par des connexions transversales. Un liquide de refroidissement est maintenu en contact avec le film poreux.

Selon une autre caractéristique de la présente invention, le film poreux est déposé au moyen d'une technique de dépôt sous vide par évaporation ou pulvérisation réactive à des pressions substantielles d'un gaz ne réagissant pas avec le matériau que l'on dépose.

Selon la présente invention, un substrat destiné à supporter un dispositif à l'état solide et à film mince sur une première surface est recouvert d'un film mince fortement poreux déposé sous vide à une température relativement basse et à une pression relativement élevée sur la surface du substrat qui est à l'opposé de la première. Ce dernier film comprend plusieurs cavités et structures capillaires microscopiques, ces dernières étant reliées par un nombre substantiel d'interconnexions transversales.

De préférence, le système de refroidissement comprend un substrat sur une surface de refroidissement duquel est déposée sous vide une structure comportant un film mince fortement poreux. Une chambre est formée par le substrat et par une enceinte destinée à maintenir un fluide de refroidissement en contact avec la structure poreuse. Cette dernière comprend un film mince poreux déposé dans une chambre à vide en présence d'un gaz qui ne réagit pas avec les composants de ladite structure.

De préférence, cette dernière comprend un film mince d'aluminium qui est déposé sous vide à une température relativement basse en présence d'un gaz inerte maintenu à une pression relativement élevée. Cette dernière devrait être supérieure à 0,5 millitorr environ (0,066 Pa). Il est souhaitable que l'épaisseur de la structure comportant le film soit au moins égale au diamètre des pores du film, de manière à assurer un piégeage substantiel du gaz dans ces pores microscopiques. Selon l'invention, ladite structure comprend de l'aluminium déposé dans de l'argon à une pression variant entre 0,5 (0,066 Pa) et 100 millitorrs environ (13,332 Pa).

De préférence, la structure à film mince poreux doit comprendre de l'aluminium déposé par pulvérisation réactive dans de l'argon maintenu à une pression comprise entre 0,5 (0,066 Pa) et 100 millitorrs environ (13,332 Pa). Cet aluminium peut également être déposé par évaporation dans de l'argon maintenu à une pression comprise entre 0,5 (0,066 Pa) et 100 millitorrs environ (13,332 Pa).

D'autres objets, caractéristiques et avantages de la présente invention ressortiront mieux de l'exposé qui suit, fait en référence aux dessins annexés à ce texte, qui représentent un mode de réalisation préféré de celle-ci.

Brève description des figures

La figure 1 est un graphique logarithmique du flux de puissance G, en unités telles que des watts/m² en fonction de la différence de température entre la température $T_s$ de la surface chaude que l'on désire refroidir et la température $T_{sat}$ qui est la température de saturation du fluide de refroidissement utilisé à la pression de fonctionnement.

La figure 2 représente une bulle formée sur une surface plate et chaude au-dessous de laquelle demeure une couche annulaire de liquide qui est dite microcouche.

La figure 3A est une coupe d'une partie d'une surface chaude dans laquelle une cavité est formée à travers laquelle un ménisque liquids s'étend, à travers un pore, jusqu'à une poche de vapeur.

La figure 3B est une coupe analogue à celle de la figure 3A dans le cas d'une cavité cylindrique.

La figure 4A est une photographie d'une coupe verticale du film d'aluminium réalisé par pulvérisation réactive dans de l'argon sous une pression élevée.

La figure 4B est une photographie d'une vue en perspective de la surface supérieure du film de la figure 4A.

La figure 4C est un agrandissement d'une partie de la photographie de la figure 4B.

La figure 5A est une photographie d'une coupe verticale d'un film d'aluminium réalisé par évaporation dans de l'argon maintenu à une pression élevée.

6

La figure 5B est une photographie d'une vue en perspective de la surface supérieure du film de la figure 5A.

La figure 6 représente un dispositif de test utilisé pour mesurer l'efficacité d'un film de refroidissement sur un substrat.

Les figures 7A et 7B sont des graphiques représentant l'injection de chaleur dans un produit de refroidissement en fonction de la température de la surface à refroidir.

La figure 8 est un graphique représentant l'injection de chaleur dans un produit de refroidissement depuis trois films d'aluminium réalisés par pulvérisation réactive dans de l'argon maintenu à trois pressions différentes, en fonction de la température de surface du substrat recouvert du film d'aluminium.

La figure 9 représente un dispositif miniature de refroidissement contenant un fluide de refroidissement destiné à refroidir une surface.

La figure 10 représente la plage des largeurs des structures obtenues au moyen de films d'aluminium réalisés par évaporation et par pulvérisation réactive, les mesures étant effectuées à partir de photographies telles que celles représentées sur les figures 4B, 4C et 5B.

Description d'un mode de réalisation

Ainsi qu'il ressort de ce qui précède, il est souhaitable de recouvrir une surface chaude au moyen d'un liquide qui bout à une température de fonctionnement désirée. De préférence, cette surface ne diot pas être lisse à moins qu'une température nettement plus élevée que celle à laquelle commence l'ébullition ne soit jugée acceptable. L'emploi d'une surface lisse peut se traduire par une surchauffe et par la destruction d'un circuit intégré formé sur un bloc lorsqu'un circuit est excité ou lorsque la quantité de puissance dissipée varie de façon très importante. D'autre part, une fois que l'ebullition a commencé, le flux de chaleur G appliqué au fluide doit être maintenu au-dessous de $G_c$, la valeur critique, afin que l'ébullition du film ne se produise pas, lorsque des bulles sont engendrées si rapidement qu'elles s'agglomèrent sur l'ensemble de la surface chaude avant de quitter celle-ci. Les films de vapeur résultant de l'ébullition séparent le liquide de la surface, si bien que le film de vapeur constitue une couche isolante qui porte rapidement la température de la surface chaude à une valeur si élevée qu'elle est inadmissible.

Diverses techniques permettent d'obtenir des points artificiels de nucléation servant à améliorer la vitesse de formation des bulles et à résoudre des problèmes tels que l'ébullition du film.

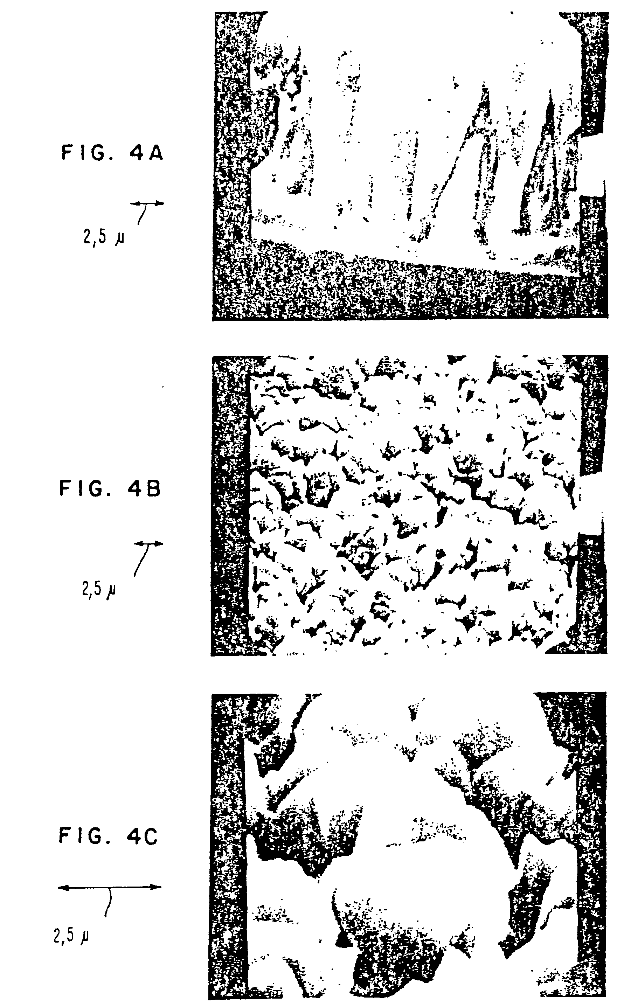

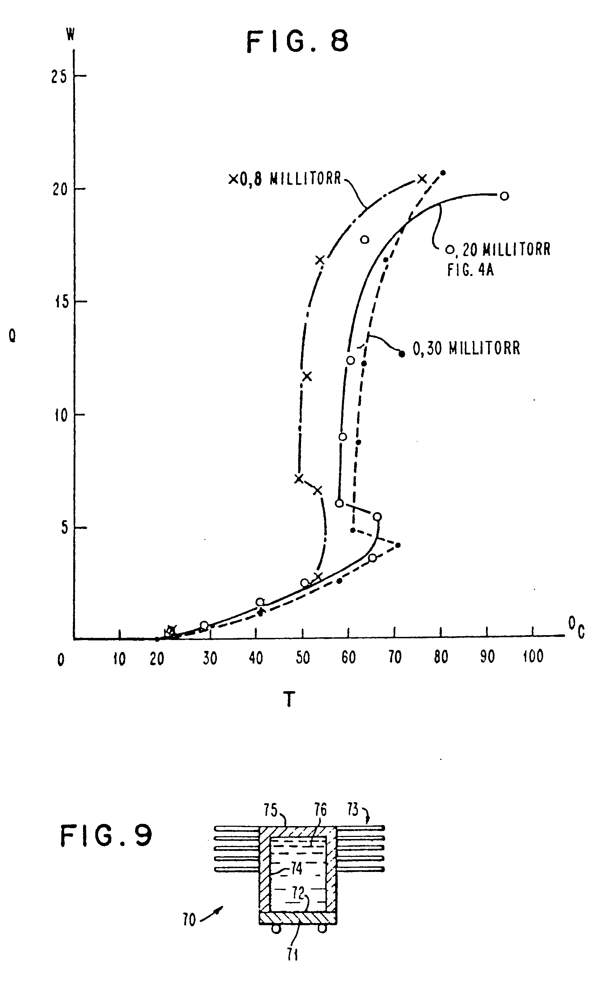

La Figure 4A représente une photographie, obtenue au moyen d'un microscope électronique à balayage, d'une coupe verticale d'un film mince d'aluminium poreux d'une épaisseur d'environ 15 microns réalisé en pulvérisant de manière réactive de l'aluminium à une pression d'argon de 20 millitorrs (2,666 Pa) sur un bloc. Cette coupe traverse une partie clivée du film et est agrandie 4000 fois; la photo est prise sous un angle de 90°. La figure 4B représente en perspective le même film d'aluminium pulvérisé vu de dessus sous un angle de 45° et agrandi 3000 fois. La figure 4C est analogue à la figure 4B, mais la vue a été agrandie 12 000 fois. La figure 4A permet d'observer des structures surprenantes comportant des interconnexions transversales substantielles et des cavités substantielles capables de piéger notamment de la vapeur, la partie supérieure comportant des ouvertures permettant à la vapeur de s'échapper et au liquide de pénétrer pendant le mouvement de va-et-vient de l'interface liquide-vapeur lors d'une ébullition active. On peut voir en se reportant à la figure 8, qu'un film de 15 microns refroidit une quantité de chaleur correspondant à 15 watts de façon stable à 60°C.

La porosité est due à la présence de pores verticaux reliés par un grand nombre de canaux d'interconnexion et permet d'utiliser les films aussi bien comme moyen d'engendrer une ébullition à nucléation que comme mèche constituant un matériau conduit de chaleur. En pareil cas, l'action capillaire de l'aluminium poreux attire le fluide de la périphérie vers la région chauffée où l'évaporation se produit. L'adjonction mécanique d'une mèche non intégrable a été citée dans l'art antérieur comme constituant une limitation grave apportée à l'emploi de conduits de chaleur directement montés sur les blocs. Cette difficulté disparaît lorsque le matériau utilisé comme mèche (c'est-à-dire l'aluminium poreux) fait partie intégrante de la structure.

La hauteur, la largeur et la densité des colonnes de métal (de l'aluminium en l'occurrence) très rapprochées les unes des autres peuvent varier en fonction de la vitesse à laquelle le dépôt est effectué et de la pression du gaz (de l'argon en l'occurrence). En ajustant les paramètres ci-dessus, on peut former des myriades de cavités du type représenté sur la figure 4A. Ce type de structure permet d'augmenter considérablement la valeur de la chaleur critique $G_c$.

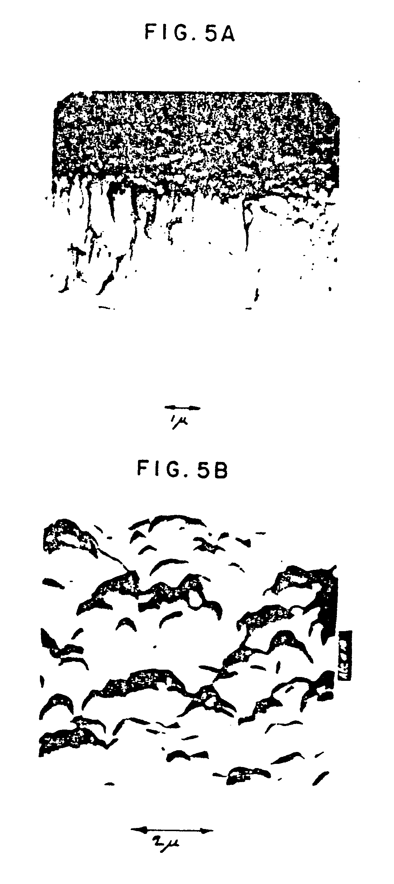

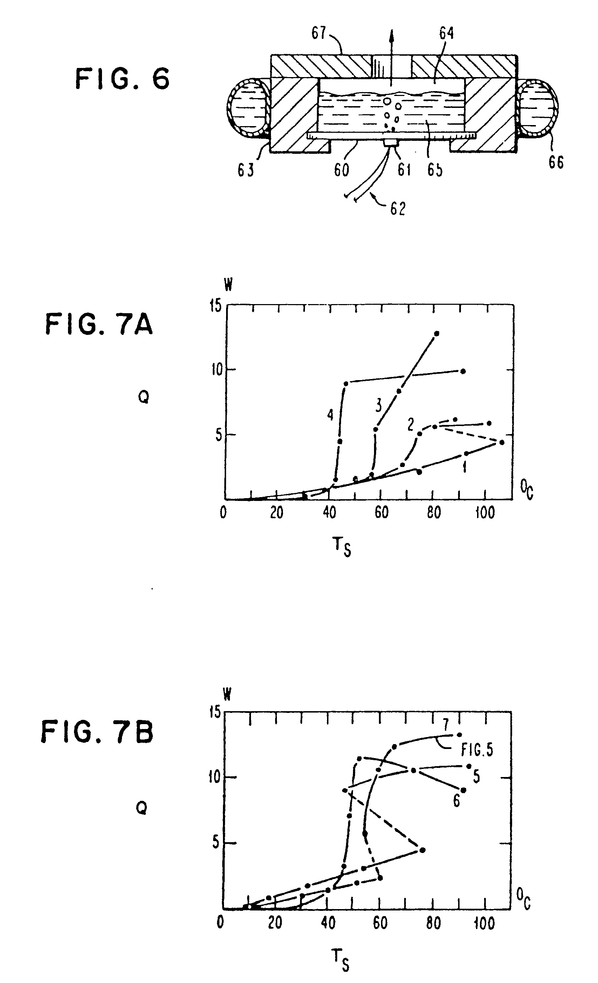

Les figures 5A et 5B sont des photographies, prises au microscope électronique à balayage, d'un film mince d'une épaisseur d'environ 4 microns réalisé par évaporation. La figure 5A représente une coupe verticale. Le film présente une apparence généralement analogue à celui de la figure 4A et est déposé sur un substrat par évaporation de l'aluminium dans une chambre à vide contenant une atmosphère d'argon à une pression de 6 millitorrs (0,800 Pa). La figure 5B est une photographie, prise sous un angle de 45°, de la surface supérieure du film. L'efficacité de ce film en tant que matériau de refroidissement set illustrée par la figure 7B, courbe 7, qui montre qu'il présente d'excellentes carac-

**0 002 996**

téristiques et permet de refroidir de façon stable à 60°C une quantité de chaleur correspondant à 10 watts.

La figure 6 représente un dispositif utilisable pour mesurer l'efficacité du refroidissement d'un film mince donné appliqué sur une pastille de silicium 60 de type n qui peut avoir un diamêtre de 3,2 cm et présenter une résistivité de 10 ohm-cm. Une bande de chauffage 61 est réalisée par évaporation sur la partie inférieure de la pastille 60, à l'endroit où un circuit intégré aurait été déposé si la pastille faisait partie d'un système de circuits intégrée. La bande 61 se compose de chrome (500Å) et de platine (2000Å). Les dimensions de la bande 61 sont initialement de 0,32 cm×1,9 cm. Toutefois, une fois que des bornes électriques ont été fixées à ses extrémités, la longueur de la bande 61 est ramenée à 1,3 cm. Un thermocouple 62 en chromel-alumel permet de contrôler la température au centre de la bande 61. Son extrémité est recouverte d'une résine époxyde destinée à la rendre électriquement isolante et est ensuite fixée mécaniquement au dispositif de chauffage. La pastille est fixée à un anneau en cuivre 63 refroidi par eau, et la chambre 64 est remplie d'un matériau de refroidissement fluorocarboné 65 tel que du "Fréon 113". Le courant et la tension sont contrôlés de façon permanente. L'anneau 63 est refroidi par une bobine de refroidissement 66. L'appareil comprend un couvercle 67 qui comporte une ouverture par laquelle la vapeur provenant du matériau de refroidissement 65 peut s'échapper de la chambre 64.

Lorsque le côté poli d'une pastille est exposé à un fluorocarbone tel que le "Fréon 113", l'ébullition commence lorsque la bande 61 atteint une température de 100°C. Lorsque le flux critique $G_c$ est atteint, une chaleur correspondant à 4 watts est dissipée dans le fluide directement au-dessus de la bande 61. Lorsqu'on utilise une pastille recouverte d'aluminium poreux, l'ébullition commence dès que la bande 61 atteint 60°C. Dans ce cas, le flux critique $G_c$ correspond à une dissipation de puissance de 9 watts.

Deux tests distincts sont effectués pour chaque surface: l'un d'eux lorsque la cellule est séche et l'autre lorsqu'elle est remplie du fluide 65. Pour calculer la puissance effectivement dissipée par le fluide 65 à une certaine température du film, la puissance d'entrée appliquée à une cellule sèche et qui correspond à cette température est soustraite de la puissance d'entrée appliquée à la cellule humide. Jusqu'à ce que la surface commence à bouillir, les courbes qui établissent une relation entre la puissance et la température coïncident presque. Cela implique que, en l'absence d'ébullition la quasi totalité de la chaleur traverse la pastille 60 et parvient à la paroi 63. La faible quantité de chaleur qui est injectée dans le liquide est le résultat d'une convection naturelle. C'est directement au-dessue de la bande de chauffage que la force de la convection est la plus grande. Lorsque l'ébullition se produit, la configuration de surface des bulles épouse approximativement la forme de la bande 61. La chaleur pénétre dans le liquide 65 directement au-dessus de la bande 61, ou au contraire traverse la pastille 60 et parvient à la paroi 63. Le flux de chaleur associé à une température de surface est calculé en divisant la différence ci-dessus par la surface de la bande de chauffage, soit 0,39 cm².

Un résumé des résultats de certaines expériences effectuées sur une surface rugueuse est illustré par les figures 7A et 7B, qui montrent l'injection de chaleur mesurée dans du fluorocarbone "Fréon 113" en fonction da la température de surface pour différents traitements de surfaces en silicium: (courbe 1) Si poli et décapé; (Courbe 2) Si poli; (Courbe 3) Si poreux $n^-$ (d'une épaisseur de 4 microns); (Courbe 4) Si poreux $n^-$ (d'une épaisseur de 100 microns) sur la figure 7A; (Courbe 5) tungstène dendritique; (Courbe 6) surface sablée (abrasif à particules de 27 microns); (Courbe 7) aluminium poreux déposé à une pression de 6 millitorrs (0,800 Pa) ainsi qu'on l'a indiqué à propos des figures 5A et 5B et d'une épaisseur de 4 microns sur la figure 7B.

Tous les procédés permettent d'abaisser la température de surface requise pour provoquer l'ébullition du fluorocarbone "Fréon 113" (Tbp=47,3°C) at faire passer le flux de chaleur critique à une valeur supérieure à celle du silicium poli. Les données obtenues indiquent que la chaleur injectée dans le fluide reste relativement constante à des températures suffisamment élevées. Cependant, la figure 1 montre que la température de la surface augmente de façon saisissante lorsque le flux de chaleur dépasse $G_c$. La différence résulte du fait que la chaleur peut suivre un chemin parallèle dans le silicium. Etant donné que la résistance thermique dans le mode dit d'ébullition de film est beaucoup plus importante que la valeur afférente au chemin de conduction dans la pastille, la chaleur supérieure à $G_c$ est acheminée au travers du silicium. Le système reste à la limite supérieure de la plage d'ébullition à nucléation. Pour une dissipation suffisamment importante, la conduction devient insuffisante pour la puissance excédentaire à une température inférieure à $T_c$. Au-delà de ce point, le système passe au mode d'ébullition du film. La valeur de G dans la région du plateau correspond à $G_c$ pour le système.

L'utilisation des données pour démontrer l'existence d'une hystérésis appelle quelques commentaires. En principe, on dit qu'un système présente une hystérésis lorsque, le flux de chaleur ayant fait l'objet d'une augmentation suivie d'une diminution, la température suit des chemins différents. On suppose que la totalité de la puissance est injectée dans le liquide. Lors de l'expérience, deux chemins parallèles peuvent être suivis par la chaleur, l'un d'eux dans le liquide et l'autre au travers de la pastille. A de faibles niveaux de puissance, la résistance thermique présentée par le chemin qui traverse la pastille est inférieure à celle de l'autre chemin dans le fluide. A des niveaux de puissance élevés, l'inverse est vrai. Dans le système expérimental, lorsque l'on obtient une hystérésis sous la forme d'une "superchaleur" considérable suivi d'un brusque passage à l'ébullition, non seulement la température

8

diminue brusquement, mais le flux de chaleur passant dans le fluide augmente. Cette situation présente une certaine analogic avec celle dans laquelle un bloc est monté sur un substrat au moyen d'un plot de soudure. Les plots de soudure constituent des chemins parallèles que peut suivre le flux de chaleur, au lieu de traverser la partie arrière du bloc de silicium.

L'aluminium poreux est le matériau le plus intéressant qui puisse être employé pour traiter la surface d'un substrat, du point de vue de l'abaissement de la température à laquelle l'ébullition commence, de l'augmentation de la valeur de $G_c$ et de la réduction au minimum de l'hystérésis. Le procédé est sec, peut être mis en oeuvre à de basses températures et est suffisamment délicat pour que son emploi puisse être envisagé pour le traitement des blocs. L'amélioration obtenue en ce qui concerne les caractéristiques d'ébullition est impressionnante. La courbe 1 de la figure 7A et la courbe 7 de la figure 7B montrent que la température de la pastille au début de l'ébullition est ramenée d'une valeur supérieure à 100°C à moins de 60°C. Le flux de chaleur passe de 15 watts/cm$^2$ à 32 watts/cm$^2$. L'hystérésis diminue et passe à une valeur inférieure à 5°C.

Le dépôt du film poreux peut s'effectuer à température ambiante et en utilisant des techniques classiques (évaporation et pulvérisation réactive). Si une température élevée est admissible, le procédé peut être appliqué lors d'une étape intermédiaire du processus de fabrication du dispositif, avec un effet minime sur les étapes précédentes ou ultérieures.

Le dépôt d'aluminium poreux permet de former des films mécaniquement résistants qui sont mis en contact intime avec le substrat ou le bloc de silicium.

Les expériences effectuées montrent que l'on peut faire varier la porosité en choisissant judicieusement la pression de l'argon et que l'on peut faire croître des films présentant des épaisseurs très variables (allant jusqu'à 10 microns).

Le film peut être déposé lors d'une étape de fabrication par lots dans un environnement propre et à de faibles températures, ces deux facteurs jouant un rôle critique en ce qui concerne la fiabilité et la reproductibilité des dispositifs. On a constaté que le dépôt de films d'aluminium n'avait aucun effet nuisible sur les caractéristiques des dispositifs. Il n'y a donc pas lieu de procéder à des tests dont le but serait de déterminer les effets éventuels du dépôt de tels films. La base de données existe déjà.

Les études afférentes au transfert de la chaleur montrent que des pastilles de silicium identiques traitées avec de l'aluminium poreux dissipent trois fois environ autant de puissance (18 watts) dans du fluorocarbone "Fréon 113" depuis une région de même surface (1,59mm$^2$) que des pastilles en silicium poli (traitement classique de la partie arrière). On constate une diminution importante de la "super-chaleur" ($T_s$—$T_{sat}$) nécessaire pour provoquer l'ébullition et de l'hystérésis (différence de température à un niveau de puissance donné lorsque l'ébullition se produit et lorsqu'elle ne se produit pas), dont les valeurs sont ramenées à quelques degrés. A ces deux égards, l'aluminium poreux permet d'obtenir des résultats égaux ou nettement supérieurs à ceux rendus possible par les autres traitements (sablage, emploi de silicium poreux ou de tungstène).

Des films poreux ont été réalisés dans une chambre de pulvérisation réactive de la façon décrite à propose des exemples I à III donnés ci-après, en utilisant un dispositif de pulvérisation à décharge luminescente du type indiqué dans le brevet des E.U.A. No. 3 616 450. Ledit dispositif est commercialisé sous l'appellation "Sputtergun Model S-310" par la firme Sloan Technology Corporation, 535 East Montecito Street, Santa Barbara, California 93103, E.U.A. Il est décrit dans le manuel intitulé "Installation and Operating Instructions" (référence M—617—274) daté de février 1974 et édité par cette firme.

Dans chacun des exemples I à III ci-dessous, on a fait fonctionner le dispositif dans un mode dit de prépulvérisation, sans réaliser de revêtement pour les substrate, disposés au-dessous d'un volet. Le dispositif est d'abord évacué jusqu'à obtention d'une faible pression de base. Un plasma d'argon est obtenu sprès avoir rempli le dispositif d'argon gazeux. Le matériau pulvérisé depuis la cible cylindrique frappe alors principalement le volet. Dans chaque cas, la prépulvérisation s'est poursuivie pendant 30 minutes cependant que l'argon gazeux était pompé dans le dispositif à la pression indiquée pour en chasser les impuretés.

| | EXEMPLE I | | EXEMPLE II | | EXEMPLE III | |
|---|---|---|---|---|---|---|
| | Pré-pul-vérisation | Pulvéri-sation | Pré-pul-vérisation | Pulvéri-sation | Pré-pul-vérisation | Pulvéri-sation |
| Pression de base (millitorr) | $4,0\times10^{-7}$ ($0,533\times10^{-7}$ Pa) | — | $6,1\times10^{-7}$ ($0,813\times10^{-7}$ Pa) | — | $6,6\times10^{-7}$ ($0,880\times10^{-7}$ Pa) | — |
| Gaz porteur | Argon | Argon | Argon | Argon | Argon | Argon |
| Pression de fonctionnement (millitorr) | 8 (1,066Pa) | 8 (1,066Pa) | 20 (2,666Pa) | 20 (2,666Pa) | 28 (3,732Pa) | 30 (4Pa) |
| Puissance incidents appliquée à la cathode (watts) | 450 | 450 | 450 | 450 | 450 | 450 |
| Courant de cathode (ampères) | 1,1 | 1,15 | 1,5 | 1,5 | 1,7 | 1,7 |
| Tension de cathode (volts) | 420 | 400 | 320 | 320 | 290 | 290 |
| Durée du dépôt (mn) | 30 | 265 | 30 | 250 | 30 | 250 |
| Epaisseur (microns) | 0 | 11 | 0 | 10 | — | 9,24 |
| Vitesse de dépôt (Å/mn) | 0 | 415 | 0 | 400 | — | 369 |
| Mode | | Position fixe | | Position fixe | | Position fixe |

## 0 002 996

La figure 8 est un graphique représentant la puissance Q en watts dissipée, en fonction de la température dans le cas de films déposés par pulvérisation réactive dans de l'argon gazeux à 8, 20 et 30 millitorrs respectivement (les épaisseurs respectives des films étant de 11, 10 et 9,24 microns). Comme le montre ce graphique, le film déposé à une pression de 8 millitorrs bout à une température moindre, présente une hystérésis moins importante et permet d'obtenir une dissipation de puissance plus grande à une température donnée. Par ailleurs, l'épaisseur de ce film était de 10% supérieure à celle des autres films et la durée de son dépôt était plus longue de 6%.

Les niveaux de puissance maximum sont considérablement supérieurs à ceux obtenus dans le cas du film d'aluminium précédemment réalisé par évaporation (21 watts pour un film déposé à une pression de 8 millitorrs (1,066 Pa) après une immersion de deux heures, au lieu de 13 watts précédemment).

Un dispositif standard de dépôt sous vide de films minces par évaporation comportant une pompe de diffusion à huile a été utilisé pour déposer de l'aluminium poreux dans de l'argon gazeux également. Le dispositif a été évacué jusqu'à obtention d'une pression de $10^{-3}$ millitorrs (0,133×$10^{-3}$ Pa). De l'argon a été ensuite introduit dans le dispositif au moyen d'une valve. Un pompage ininterrompu a été effectué pour maintenir une pression constante de l'argon de 0,1 à 20 millitorrs (0,013 à 2,666 Pa). Une nacelle en Ta était disposée au-dessous d'un porte-substrate rotatif comportant des évidements dans lesquels étaient logés les substrats et qui était suspendu à la partie supérieure du dispositif.

De petites billes (6,35mm) ont été placées dans cette nacelle et un courant de 260 à 280 ampères appliqué. De l'aluminium poreux a été déposé avec et sans rotation. La vitesse de dépôt était fonction de la distance séparant la nacelle du substrat ainsi que de la pression de l'argon sous laquelle l'évaporation est produite. Les vitesses de dépôt sur du silicium obtenues lors d'essais référencés A à D pour une distance variant approximativement entre 18 et 20 cm sont indiquées ci-après, les essais référencés E, F, G et I montrant les vitesses de dépôt réalisées avec une pression de 6 millitorrs telle que celle employée dans le cas des figures 5A et 5B.

| Essai | Pression | Epaisseur | Durée | Vitesse de dépôt |
|---|---|---|---|---|
| | (millitorr d'argon) | (Å) | (mn) | (Å/mn) |
| A | 0,1 (0,013 Pa) | 18000 | 6 | 3000 |
| B | 0,3 (0,04 Pa) | 16000 | 8.42 | 1900 |
| C | 0,5 (0,066 Pa) | 13000 | 4,65 | 2795,7 |
| D | 1,0 (0,133 Pa) | 8500 | 7,17 | 1185,5 |
| E | 6 (0,8 Pa) | 5100 | 4 | 1275 |
| F | 6 (0,8 Pa) | 12000 | 8 | 1500 |
| G | 6 (0,8 Pa) | 3000 | 2 | 1500 |
| H | 2 (0,266 Pa) | 7000 | 8 | 875 |
| I | 6 (0,8 Pa) | 11000 | 8 | 1375 |
| Les essais E, F et G et I sont des exemples des vitesses de dépôt obtenues pour une pression de 6 millitorrs telle que celle utilisée dans le cas des figures 5A et 5B. | | | | |

**0 002 996**

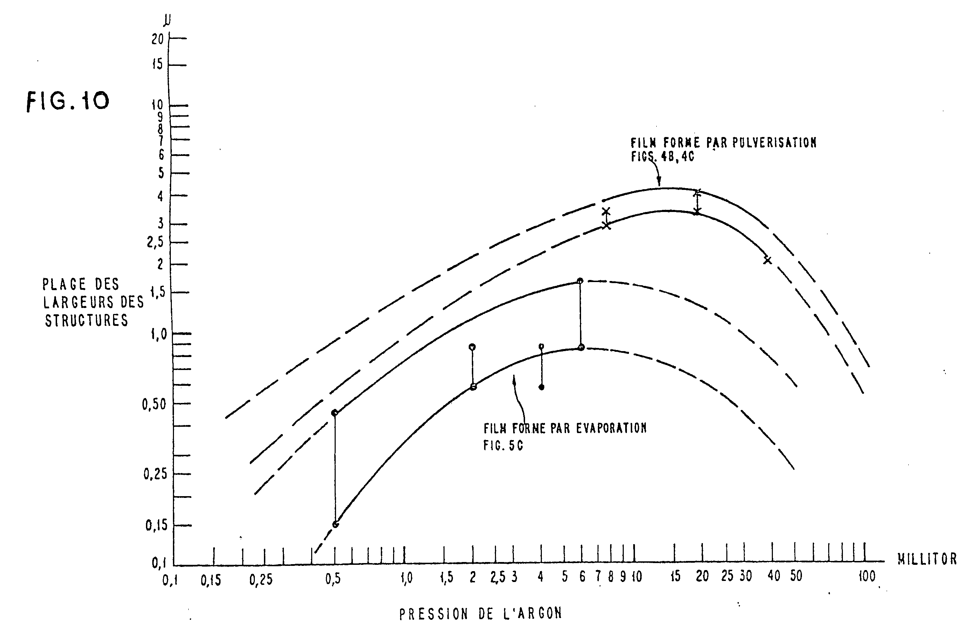

Dans le cas des films réalisés de la façon ci-dessus par évaporation et par pulvérisation réactive, les photographies de la surface des films poreux prises sous un angle de 45° au moyen d'un microscope électronique montrent que la structure qui crée les pores peut varier en fonction de la pression de l'argon. La plage des dimensions maximum et minimum de la structure est représentée sur la figure 10. Le terme dimension est defini comme étant la largeur (dimension latérale) d'une seule des structures, piliers ou colonnes représentées sur les figures 4A et 5A. Dans le cas des films réalisés par pulvérisation réactive, les structures ont été généralement plus grandes et la pression employée était généralement plus élevée. La plage maximum des dimensions des structures est produite par des pressions allant d'une fraction d'un millitorr à 100 millitorrs (13,332) environ.

Dans le dispositif de formation des films par évaporation, la vitesse de formation des films diminue nettement lorsqu'on augmente la distance entre la source en aluminium et le substrat pour une pression donnée. Cela est probablement dû au fait que les collisions entre les atomes d'aluminium et d'argon ne permettent pas un dépôt direct.

La figure 9 représente un dispositif miniature de conduction de chaleur 70 et un bloc de silicium 71 dont la surface supérieure est recouverte d'aluminium poreux 72. Ce dernier est saturé au moyen d'un fluide de refroidissement tel que du fluorocarbone. Une mèche secondaire d'aluminium poreux 74 est formée sur la surface interne d'une enceinte 75 contenant le fluide de refroidissement 76. Des ailettes 73 sont prévues pour refroidir l'enceinte 75.

On a observé sur les photographies prises à propos de la présente invention, telles que celles représentées sur les figures 4A, 4B, 4C, 5A et 5B, que pour une dimension quelconque des pores, que l'on peut voir respectivement sur les figures 4A et 5A, et pour une dimension des structures représentées, d'une part, sur les figures 4B et 4C et, d'autre part, sur la figure 5B, les dimensions des pores sont approximativement proportionnelles à celles des structures. Par exemple, une structure de dimension maximum indique que le film qui se trouve au-dessous d'elle a des pores de dimension maximum.

Le fait qu'un pore présente une grande largeur est un facteur important pour obtenir un refroidissement satisfaisant, ainsi qu'il ressort de ce qui précède. Toutefois, les films les plus minces dont les pores ont de grandes dimensions tendent à être plus ouverts, comme sur la figure 3B, et de ce fait, bien que des pores de grandes dimensions soient une condition nécessaire, cette condition n'est pas suffisante parce que l'épaisseur du film doit être au moins égale aux dimensions du pore afin que le gaz puisse être retenu dans les pores et afin d'empêcher ces derniers de se remplir de liquide. Cependant, si les pores sont de très grandes dimensions, la probabilité pour qu'ils se remplissent de liquide de refroidissement augmente. En revanche, si les pores ne se remplissent pas de ce liquide, on obtient un meilleur refroidissement.

On a constaté que les films les plus épais permettent d'obtenir un meilleur refroidissement parce qu'ils ne se remplissent pas de liquide aussi facilement que les autres films. Les films réalisés par évaporation, tels que ceux représentés sur les figures 5A et 5B, étaient plus minces que ceux des figures 4A à 4C et, comme on peut le voir, le refroidissement représenté sur la figure 8, qui correspond au film de 15 microns d'épaisseur des figures 4A et 4B, est supérieur à celui du film de 4 microns d'épaisseur des figures 5A à 5C, comme le montre la courbe 7 de la figure 7B.

Aux pressions plus élevées, les structures redeviennent plus petites car les atomes du gaz exercent une plus grande pression sur le film déposé, si bien que l'on obtient un film plus lisse.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

**Revendications**

1. Support de dispositifs actifs à l'état solide conducteur de la chaleur, les dispositifs étant disposés sur une surface de ce support,
caractérisé en ce que:
il comporte sur la surface opposée à celle portant les dispositifs, un film mince poreux dont les pores sont constitués par des cavités et des structures capillaires microscopiques, des interconnexions transversales reliant ces cavités entre elles et ces structures capillaires entre-elles.

2. Support de dispositifs actifs à l'état solide selon la revendication I caractérisé en ce que l'épaisseur du film mince poreux est au moins égale aux dimensions de ses pores.

3. Support de dispositifs actifs à l'état solide selon la revendication 1 ou 2 caractérisé en ce que le film mince poreux est composé d'aluminum.

4. Support de dispositifs actifs à l'état solide selon l'une des revendications 1 à 3 caractérisé en ce que les cavités ont un diamètre inférieur à 5 $\mu$.

5. Procédé de fabrication du support de dispositifs actifs à l'état solide, selon l'une des revendications 1 à 4 caractérisé en ce que le film mince poreux est déposé sur le support dans une chambre à vide en présence d'un gaz inerte.

# 0 002 996

6. Procédé de fabrication du support de dispositifs actifs à l'état solide selon la revendication 5 caractérisé en ce que le gaz inerte est de l'argon.

7. Procédé de fabrication du support de dispositifs actifs à l'état solide selon la revendication 5 ou 6 caractérisé en ce que le gaz inerte est maintenu à une pression comprise entre 0,5 et 100 millitorrs (0,066 Pa et 13,332 Pa).

8. Procédé de fabrication du support de dispositifs actifs à l'état solide selon l'une des revendications 5 à 7 caractérisé en ce que le film mince poreux est déposé par pulvérisation réactive.

9. Procédé de fabrication du support de dispositifs actifs à l'état solide selon l'une des revendications 5 à 7 caractérisé en ce que le film mince poreux est déposé par évaporation.

10. Utilisation du support de dispositifs actifs à l'état solide, selon l'une quelconque des revendications 1 à 9, dans un dispositif de refroidissement des dispositifs actifs caractérisé en ce que:

une chambre est formée par ce support et une enceinte pour maintenir un fluide de refroidissement en contact avec le film mince poreux.

## Patentansprüche

1. Wärmeleitendes Substrat mit aktiven Festkörperbauelementen, wobei die Bauelements auf einer Oberfläche dieses Substrats angeordnet sind,
dadurch gekennzeichnet, dass
auf der der die Bauelemente tragenden Oberfläche gegenüberliegenden Oberfläche eine poröse Dünnschicht aufgebracht ist, deren Poren aus einer Vielzahl von mikroskopischen Höhlungen und Kapillarstrukturen bestehen, wobei diese Höhlungen untereinander und diese Kapillarstrukturen untereinander durch Querverbindungen verbunden sind.

2. Substrat mit aktiven Festkörperbauelementen nach Anspruch 1, dadurch gekennzeichnet, dass die Dicke der porösen Dünnschicht wenigstens der Grösse ihrer Poren entspricht.

3. Substrat mit aktiven Festkörperbauelementen nach Anspruch 4 oder 2, dadurch gekennzeichnet, dass die poröse Dünnschicht aus Aluminium besteht.

4. Substrat mit aktiven Festkörperbauelementen nach einem der Ansprüche 1 bis 3, dadurch gekennzeichnet, dass die Höhlungen einen Durchmesser von weniger als 5 $\mu$m haben.

5. Verfahren zum Herstellen des Substrats mit aktiven Festkörperbauelementen nach einem der Ansprüche 1 bis 4, dadurch gekennzeichnet, dass die poröse Dünnschicht in einer Vakuumkammer in Gegenwart eines Inertgases aufgebracht wird.

6. Verfahren zum Herstellen des Substrats mit aktiven Festkörperbauelementen nach Anspruch 5, dadurch gekennzeichnet, dass das Inertgas aus Argon besteht.

7. Verfahren zum Herstellen des Substrats mit aktiven Festkörperbauelementen nach Anspruch 5 oder 6, dadurch gekennzeichnet, dass das Inertgas unter einem zwischen 0,5 und 100 millitorr (0,066 Pa und 13,332 Pa) liegenden Druck gehalten wird.

8. Verfahren zum Herstellen des Substrats mit aktiven Festkörperbauelementen nach einem der Ansprüche 5 bis 7, dadurch gekennzeichnet, dass die poröse Dünnschicht durch reaktives Zerstäuben aufgetragen wird.

9. Verfahren zum Herstellen des Substrats mit aktiven Festkörperbauerlementen nach einem der Ansprüche 5 bis 7, dadurch gekennzeichnet, dass die poröse Dünnschicht durch Aufdampfen aufgetragen wird.

10. Verwendung des Substrats mit aktiven Festkörperbauelementen nach einem der Ansprüche 1 bis 9 in einer Vorrichtung zum Kühlen der aktiven Bauelemente, dadurch gekennzeichnet, dass durch dieses Substrat eine Kammer und eine Einfriedigung gebildet wird, um eine Kühlflüssigkeit in Berührung mit der porösen Dünnschicht zu halten.

## Claims

1. A heat-conducting substrate with solid-state, active devices placed on one surface thereof, characterized in that
It comprises a porous thin film on the surface opposite the surface carrying the devices, the pores of said thin film consisting of a plurality of microscopic cavities and capillary structures, and transverse interconnections to interconnect said cavities and to interconnect said capillary structures.

2. A solid-state, active device substrate according to claim 1, characterized in that the thickness of the porous thin film is at least equal to the size of its pores.

3. A solid-state, active device substrate according to claim 1 or 2, characterized in that the porous thin film is composed of aluminium.

4. A solid-state, active device substrate according to any one of claims 1 to 3, characterized in that the diameter of the cavities is less than 5$\mu$.

5. A method for manufacturing the solid-state, active device substrate according to any one of claims 1 to 4, characterized in that the porous thin film is deposited on the substrate in a vacuum chamber in the presence of an inert gas.

6. A method for manufacturing the solid-state, active device substrate according to claim 5, characterized in that the inert gas is argon.

7. A method for manufacturing the solid-state, active device substrate according to claim 5 or 6, characterized in that the inert gas is maintained at a pressure between 0.5 and 100 millitorrs (0.066 Pa and 13.332 Pa).

8. A method for manufacturing the solid-state, active device substrate according to any one of claims 5 to 7, characterized in that the porous thin film is deposited by reactive sputtering.

9. A method for fabricating the solid-state, active device substrate according to any one of claims 5 to 7, characterized in that the porous thin film is deposited by evaporation.

10. Use of the solid-state, active device substrate according to any one of claims 1 to 9, in a device for cooling active devices, characterized in that:

a chamber is formed by said substrate and an enclosure for holding a cooling fluid in contact with the porous thin film.

0 002 996

# FIG. 1

| CONVECTION + CONDUCTION | EBULITION A NUCLEATION | EBULITION INSTABLE | EBULITION DU FILM |

$G_C$

COURBE D'EBULITION

LOG G

COURBE D'HYSTERESIS

DEBUT DE L'EBULITION

$(T_S - T_{SAT})_C$

$LOG\ (T_S - T_{SAT})$

# FIG. 2

CONDENSATION DANS LA MASSE DU FLUIDE

10

11

12

7

EVAPORATION DEPUIS LA COUCHE LIMITE THERMIQUE

9

8

EVAPORATION DE LA MICROCOUCHE

1

# FIG. 3A

# FIG. 3B

FIG. 4A

2,5 µ

FIG. 4B

2,5 µ

FIG. 4C

2,5 µ

FIG. 5A

$\overset{\longleftrightarrow}{1\mu}$

FIG. 5B

$\overset{\longleftrightarrow}{2\mu}$

FIG. 6

FIG. 7A

FIG. 7B

# FIG. 8

×0,8 MILLITORR

○ , 20 MILLITORR
FIG. 4A

0,30 MILLITORR

# FIG. 9

FIG. 10

FILM FORME PAR PULVERISATION
FIGS. 4B, 4C

FILM FORME PAR EVAPORATION
FIG. 5C

PLAGE DES
LARGEURS DES
STRUCTURES

MILLITOR

PRESSION DE L'ARGON

0 002 996